# EUROPEAN PATENT APPLICATION

(11) **EP 3 104 507 A1**
(43) Date of publication of application: **14.12.2016**
(21) Application number: 15171929.1
(22) Date of filing: 12.06.2015
(51) Int. Cl.: H02M 1/44, H02M 7/00

(54) **TERMINAL ARRANGEMENT FOR A POWER SEMICONDUCTOR MODULE**

(71) Applicant: ABB Technology AG, 8050 Zürich (CH)
(72) Inventor: Traub, Felix, 4310 Rheinfelden (CH); Skibin, Stanislav, 5415 Nussbaumen (CH); Mohn, Fabian, 5408 Ennetbaden (CH); Cottet, Didier, 8050 Zürich (CH); Schuderer, Jürgen, 8047 Zürich (CH); Kicin, Slavo, 8049 Zürich (CH); Hartmann, Samuel, 5603 Staufen (CH)
(74) Representative: ABB Patent Attorneys

(57) **Abstract**

The present invention relates to a terminal arrangement for externally contacting an electronic circuit of a power semiconductor module, the terminal arrangement comprising a first external terminal (10), a second external terminal (12) and at least one shield member (26) for at least partly shielding an electromagnetic field (15) originated from said first external terminal (10) and said second external terminal (12), wherein in a shielding region (11) of the first external terminal (10) at least one shield member (26) is located at a distance to the first external terminal (10) in a direction perpendicular to a longitudinal extension of first external terminal (10) and wherein and in a shielding region (13) of the second external terminal (12) at least one shield member (26) is located at a distance to the second external terminal (12) in a direction perpendicular to a longitudinal extension of second external terminal (12), wherein the distance is equal or less than at least one of the maximum width (30) of the first external terminal (10) and the second external terminal (12) in said shielding region (11, 13) of the first external terminal (10) and the second external terminal (12), and the maximum distance between the first external terminal (10) and the second external terminal (12) in said shielding region (11, 13) of the first external terminal (10) and the second external terminal (12). Such a terminal arrangement provides a low stray inductance and/or may be built easily.

## Description

### Technical Field

The Invention relates to a terminal arrangement for a power semiconductor module for externally contacting an electronic circuit of the power semiconductor module. In particular, the invention relates to a terminal arrangement for a power semiconductor module allowing a low stray inductance and thus an improved working behaviour of the power semiconductor module. The invention further relates to a power semiconductor module comprising such a terminal arrangement.

### Background Art

Power semiconductor modules are known as such and used in a broad application range. Power semiconductor modules may comprise power semiconductor switches which may switch currents of more than 10 A and/or more than 500V.

The trend in power semiconductor technology goes into the direction of fast-switching devices. Shorter switching times can be obtained by optimizing silicon (Si) based devices as well as using devices based on wide band gap semiconductor materials, e.g., silicon-carbide (SiC) or gallium-nitrite (GaN). However, electromagnetic parasitics in the power module give rise to severe switching distortions in power modules, thereby limiting the maximum achievable switching times.

Regarding the above, power electronic modules for fast switching semiconductors therefore require very low stray inductance.

In fact, in a converter for example, the commutation loop stray inductance causes voltage overshoots during switching, produces EMI emissions by ringing, and increases the switching losses. The power semiconductor package is part of the commutation loop, therefore minimizing its stray inductance is mandatory.

As a general rule, the stray inductance is determined by the physical area of the commutation cell. In 2D, the current paths have to be placed next to each other. The physical area of the commutation cell is then roughly proportional to the footprint area of the substrate. In practice, the stray inductance of standard planar power modules can therefore not easily be reduced to values below ∼5-10nH. For fast switching semiconductors with rise-times of ∼10ns, this value is under circumstances not acceptable.

Document EP 1 868 243 A1 describes a power semiconductor module comprising a substrate and at least two power semiconductor chips which are arranged on said substrate. Further, two external terminals are provided which are partly formed belt-like and which are insulated against each other by providing an electrical insulator for enclosing the terminals therewith at their belt-like structure.

Document DE 10 2009 035 819 A1 describes a power semiconductor module which comprises at least two sub-circuits. Provided are external terminals which are formed belt-like.

Document DE 195 22 172 C1 describes a power semiconductor module which comprises external terminals which are described to have an improved ampacity and to be contactable by wave soldering. Such terminals are formed of an upper part comprising at least two pins and of a lower part which is formed rectangular.

Document EP 0 789 446 A1 describes a power semiconductor module which comprises a power circuit being positioned in a housing. Two external terminals are provided which proceed out of the housing and between which an insulating plate may be arranged.

The state-of-the-art design solution to minimize terminal stray inductance thus comprises the so-called stripline terminal concept. According to this concept, terminals are realized as wide conductors placed at a close distance. In other words, the stripline concept shows two belt-like terminals which are located one onto the other, the width of each conductor being aligned in a horizontal direction. This terminal design allows in general very low stray inductance. However, the stripline design cannot be applied in a straightforward way to the design of the external connectors, where creepage and clearance distances require a certain minimum distance between the DC+ and DC-conductors, in other words, where the stripline has to be "opened".

Especially regarding power semiconductor modules having low stray inductance, there is thus still potential for improvements.

### Summary of invention

It is therefore an object of the present invention to provide an improved power semiconductor module which shall obviate at least one of the disadvantages known in the art.

In particular, it is an object of the present invention to provide a measure which provides a power semiconductor module having the capability to work with low stray inductance and/or which is easy to build especially by using state of the art techniques.

These objects are at least partly achieved by a terminal arrangement for a power semiconductor module according to claim 1. These objects are further at least partly achieved by a power semiconductor module according to claim 12. Preferred embodiments of the present invention are defined in the dependent claims.

The invention relates to a terminal arrangement for externally contacting an electronic circuit of a power semiconductor module, the terminal arrangement comprising a first external terminal, a second external terminal and at least one shield member for at least partly shielding an electromagnetic field originated from said first external terminal and said second external terminal, wherein in a shielding region of the first external terminal at least one shield member is located at a distance to the first external terminal in a direction perpendicular to a longitudinal extension of first external terminal and wherein and in a shielding region of the second external terminal at least one shield member is located at a distance to the second external terminal in a direction perpendicular to a longitudinal extension of second external terminal, wherein the distance is equal or less than at least one of the maximum width of the first external terminal and the second external terminal in said shielding region of the first external terminal and the second external terminal, and the maximum distance between the first external terminal and the second external terminal in said shielding region of the first external terminal and the second external terminal.

A terminal arrangement like defined above allows a power semiconductor module to work with low stray inductance and is further easy to produce. Therefore, the terminal arrangement provides a measure for realizing power module terminals which allow low stray inductance, and which is applicable to all current classes of power modules.

In detail, a terminal arrangement as described above comprises at least two external terminals. The external terminals may have different applications depending on the topology of the module. Particularly terminals may respectively be used as a positive and negative direct current terminals (DC+ terminal or DC-terminal) or as an AC-terminal, respectively, for example for a half bridge module, or the terminals may respectively be used as collector and emitter terminal for a single switch module, for example. The terminals are thus particularly designed for proceeding from the electronic circuit of the power semiconductor module to a position for externally contacting said terminals and thus, for example, through a housing of the module.

With this regard, an electronic circuit of a power semiconductor device as it is generally known in the art mainly comprises at least one power semiconductor device, such as a transistor, e.g. a MOSFET or an IGBT, and/or a diode, which at least one power semiconductor device is connected to an electrically conductive structure. The external terminals may exemplarily serve for contacting such an electrically conductive structure at its one ends of their longitudinal extension and may provide an external connection point, for example outside a housing of the module, at the opposite end of the longitudinal extension of the external terminals.

The terminals thus particularly have a current carrying capability for carrying currents which are typical for respective terminals in power semiconductor modules. In a nonlimiting example, the terminals have a current carrying capability of at least 10A, such as up to 50A or even significant more, such as 100A or more.

The terminal may be formed by a conductor, such as a metallic conductor, for example formed from copper or copper alloys, for example.

Next to the terminals as it is described in detail above, the terminal arrangement further comprises at least one shield member for at least partly shielding an electromagnetic field originated from said first external terminal and said second external terminal. Particularly, the at least one shield member is designed for shielding an electromagnetic field which is originated from a shielding region of the two terminals.

There might be only one shield member or there might be more than one shield members without leaving the invention like it will be described in detail down below.

Especially in case one shield member for the first and the second terminal is provided, wherein particularly the first and the second terminals are provided in close distance to each other, one shield member may be sufficient for shielding both terminals or at least the respective shielding regions of the latter. Therefore, this embodiment further improves the producability of the module.

Regarding the shielding regions of the terminals, it may be provided that the shielding regions of the different terminals at least partly, preferably completely, are located in vicinity to each other. For example, they may at least partly, preferably completely, overlap in a direction normal to at least one plane and have a distance in that direction like it is described in detail for the distance between the two terminals down below.

In case two shield members are provided, an improved adaption to the respective requirements may be achieved regarding the shielding effect of each of the terminals.

The terminal arrangement thus comprises a shield member, or shielding, respectively, which is provided and positioned for shielding at least a part of the electromagnetic field which is formed and which is originated in the external terminal and particularly in a shielding region of the latter. Such an electromagnetic field may be formed, for example, during a switching process of a power semiconductor device of the power semiconductor module. Therefore, the shield member may be positioned adjacent to the terminals and particularly adjacent to the shielding region of the external terminals. Next to the field which is originated in the shielding region of the external terminals, it may additionally be provided that the shield member shields at least a part of the electromagnetic field which is originated from a point of the external terminals other than the shielding region without leaving the present invention.

In order to achieve an especially effective shielding effect, it may be advantageous, that the shield member is positioned in close proximity to said shielding region of the external terminals. Therefore, the shielding region of the terminals may describe that region, at which the shield member is located at a defined distance to the terminals. In detail, in a shielding region of the first external terminal at least one shield member is located at a distance to the first external terminal in a direction perpendicular to a longitudinal extension of first external terminal and wherein and in a shielding region of the second external terminal at least one shield member is located at a distance to the second external terminal in a direction perpendicular to a longitudinal extension of second external terminal, wherein the distance is equal or less than at least one of the maximum width of the first external terminal and the second external terminal in said shielding region of the first external terminal and the second external terminal, and the maximum distance between the first external terminal and the second external terminal in said shielding region of the first external terminal and the second external terminal. In fact, in the shielding region, the maximum distance as described above may be that distance out of the maximum width of the terminals and the distance between the terminals, which has a larger value. In case these values are not constant, the largest value may be taken into consideration.

Regarding the largest width, this may for example be the width in a rectangular form or the diameter in a circular form.

It may further be provided that the specific distance of the at least one shield member to the first external terminal and the second external terminal is more than 0mm or in other words, the shield member is spaced apart from the first external terminal and the second external terminal. This may realize an especially effective shielding effect.

However, it may further be provided that the shield member is directly in contact with one respective terminal and thus the distance is 0. However, as it is clear for the person skilled in the art, in case the shield member is electrically conductive, a short circuit has to be avoided so that the shield member can be isolated and thus be located spaced apart with respect to both terminal conductors or in electrical contact with at most one of the terminal conductors, in case one common shield member is provided, and insulated with regard to the further terminal.

It may therefore be advantageous, that a shield member is provided for at least partly shielding a magnetic field from the shielding region of both the first external terminal and the second external terminal, wherein the shield member is fully electrically insulated from at least one of the first external terminal and the second external terminal. For example, one respective shield member may be provided. This may allow an especially easy and cost-saving embodiment, as only one shield member has to be used for shielding both of the first and the second external terminal. Further, an especially effective shielding effect may under circumstances be achieved.

Such a shield member may thus be arranged adjacent to both terminals and may thus have the respective maximum distance to both terminals.

It is, however, not excluded from the present invention that a first shield member is provided for at least partly shielding a magnetic field from the shielding region of the first external terminal and that a second shield member is provided for at least partly shielding a magnetic field from the shielding region of the second external terminal, wherein the maximum distance between the first and the second shield member in the shielding region is smaller than the maximum distance between the first external terminal and the second external terminal in the shielding region, in case the different shield members are located spaced apart.

According to this, the first shield member may be arranged in the respective maximum distance to only the first terminal or both of the terminals, whereas the second shield member may be arranged in the respective maximum distance to only the second terminal or both of the terminals.

For example, the maximum distance between the first and the second shield member in the shielding region is in a range of smaller than 50%, particularly smaller than 10%, exemplarily smaller than 5% of the maximum distance between the first external terminal and the second external terminal in the shielding region. This embodiment may allow an improved adaption to the desired application, especially in case the terminals differ from each other.

Independently of the respective embodiment of the terminal arrangement, it is advantageous for an especially effective shielding effect that the minimum distance between the shield member and the external terminal respects a breakdown distance. Therefore, a distance might be comparably large in case air or a further gas is provided between the shield member and the external terminals. It might however be comparably small in case an electrical insulator is provided between the shield member and the external terminal. With this regard, it might be advantageous in case an insulator having a high breakdown field is used.

Exemplary minimum distances between the terminal and the shield member if these parts are located spaced apart from one the other may lie in the range of ≥ 10µm to ≤ 1000µm, preferably of ≥ 25µm to ≤ 750µm, exemplarily of ≥ 50µm to ≤ 500µm. The specific value may be determined by taking into consideration the voltage the power module is designed for as well as the breakdown field of the material being between the shield member and the respective terminal.

The shield member thus may be positioned such, that at least a portion, or preferably the whole shield member, is provided at or below a maximum distance from the external terminals. Said maximum distance is preferably determined at a distinct position or at a plurality of positions of the external terminal, said position being at the shielding regions of the external terminals and at the surface of the terminals, the surface being directed towards the shield member. Further, the distance may be determined in a direction perpendicular to a longitudinal extension of the terminals at said position or positions of the terminals and thus parallel to the width or, advantageously, the height of said shielding region of the external terminals in case they are formed belt like, like described down below.

It is further provided that the maximum distance corresponds to the width of the external terminal or the distance between said terminals at that point at which said distance is determined. A part of the shield or the whole shield may thereby particularly mean the extension of the shield parallel to the longitudinal extension of the external terminals.

With this regard, the distance may refer to the shield member and thus to an active part of a shielding arrangement, only, such as to an electrically conductive structure, such as a metallic layer, for example. The latter may under circumstances be of importance, in case the active part and thus the shield member, such as a conductor, for example, is embedded in a certain structure, such as an electrical insulating structure, of the shield arrangement. In such a case, it may be sufficient that the active part, i.e. the conductor is respectively arranged, an electrically resistive structure or further essentially non-active parts may, however, be positioned out of such a distance or may be closer to the terminal and may under circumstances be directly connected to said terminal, in case the shield member is spaced apart from the respective terminal.

As an example, the respective distance between the shield member and the terminals may be equal or less than half the width, in particular, equal or less than 10% of the width, for example, equal or less than 2% of the width, exemplarily equal or less than 1 % such as equal or less 0.1 % of the width of the terminal or of the distance between the terminals at said respective position, wherein, like stated above, a minimum distance which is dependent on the breakdown distance may be advantageous.

The shield member may be formed belt-like and may be aligned at least partly parallel to the longitudinal extension of the terminals.

Exemplary dimensions of the terminal at least in the respective shielding region may comprise widths of ≥ 2cm to ≤ 6cm and heights of ≥0,5mm to ≤ 4mm, preferably ≥ 1 mm to ≤ 2mm.

Respective distances between the terminals at said positions may lie in the range of ≥ 1 mm to ≤ 10 mm, particularly from ≥ 4mm to ≤ 8 mm.

Thus, the first and the second external terminals should be located in proximity to each other. It is thereby possible without significant problems to respect creepage and clearance distances regarding the external terminals without significantly compromising the stray inductance. Regarding the flexibility of the terminal design, for example, clearance and creepage distances require minimum distance between external connectors, or external terminals, respectively, which however is not problematic at the present terminal arrangement.

Due to the provision of at least one shield member for reducing electromagnetic fields originated from the external terminals, significant advantages over solutions of the prior art may be achieved.

In detail, the terminal arrangement as described allows the power semiconductor module to work with very low stray inductance independently of the used voltage, i.e. for low to high voltage power modules as well as for low to high current power modules.

During the IGBT and diode switching event, for example, the stray inductance of the internal IGBT module design are creating an overvoltage at the semiconductor terminals. With the reduction of the internal stray inductance, this overvoltage can be reduced. If additionally chips are paralleled inside the module, it is important to have the same inductance from each chip to the terminals. In this way oscillations and unsymmetrical current distribution are reduced or avoided. Therefore, a low inductive and symmetric concept positively influences clean switching in a power module.

The stray inductance may be decreased especially effectively by such a terminal arrangement as the terminal design takes advantage of the effect, according to which stray inductance is determined at a large amount by the design of the power terminals. In detail, it could be observed that more than 2/3 of the total module stray inductance is already due to terminal stray inductance. This finding highlights the effectiveness of adapting a power terminal especially for fast switching semiconductors. It thus has been found that especially the arrangement of the external terminals is highly contributing to the stray inductance.

The terminal arrangement as described here allows providing essentially comparable advantages with regard to the stripline concept according to the prior art, in particular with regard to stray inductance, thereby, however, not showing at least some of the disadvantages of said stripline concept. Thus, especially regarding the stripline concept according to the prior art at last some of the disadvantages which are shown by said terminal design may be overcome by a terminal arrangement according to the present invention.

In detail, the terminal arrangement as described has an improved and high design flexibility especially in contrast to the known stripline concept, which stripline concept provides only low design flexibility as the terminal stripline must not be opened at any point in order to work properly according to the prior art. Therefore, according to the present terminal arrangement, it can be avoided or at least significantly reduced that design rules are in conflict with additional requirements of terminal design.

Apart from that, terminals often are thick solid conductors to carry the rated current. Typically, they are bent to form the required structure. According to the prior art, this may lead to a design with poor geometrical accuracy and minimizing their mutual distance is not straightforward. This, however, may be overcome by the terminal design as described.

Furthermore, conventional module terminals as known in the art may be embedded in silicone gel. However, according to prior art solutions, it is under circumstances difficult to ensure a complete filling of all the volume being in vicinity to the terminals, such as to stripline terminals. According to the present terminal arrangement, however, embedding of the terminals in silicone gel may under circumstances be enhanced then allowing an improved insulation as well as thermal behavior of a module being equipped with such a terminal arrangement.

At the same time when overcoming at least some of the disadvantages of prior art solutions like described before, the main advantages may be achieved at least in a comparable manner. In detail, low stray inductance may be reached like it is described above and further it may be allowed to provide DC terminals by design having a comparably large distance from each other, anyhow enabling a low inductive connection to DC-busbar, for example.

Apart from that, such a terminal arrangement is producible by simple mechanical realization and may, when producing a power semiconductor module, be completely integrated into a conventional module housing. This is especially the case if the shield member, or a shield arrangement which comprises said shield member, is positioned at least partly, advantageously completely, inside a housing of a power module. Therefore, no significant additional requirements appear for producing the power semiconductor module.

This allows the terminal arrangement and accordingly the power semiconductor module comprising such a terminal arrangement to be producible very easily and with techniques well known and established for power semiconductor modules. Therefore, the terminal arrangement may be produced without a significant cost-increase and may further be introduced into present production lines and into state of the art modules without significant problems and is thus immediately applicable to existing and future power modules.

Following the above, according to the terminal arrangement as described, it is no longer required like known in the art to form a stripline by two current carrying conductors, or terminals, respectively, placed at a small distance above one another. According to the present invention, the same or at least a comparable effect can also be achieved by placing both terminals close to one or more exemplarily common shield members such as formed by one or more electrical conductors.

To summarize a terminal arrangement as described is producible easily and provides very low stray inductance during work of a power semiconductor module.

According to an embodiment, the shielding region of the first external terminal and the shielding region of the second external terminal are formed belt-like. A belt-like form is generally known for one of the terminals arranged in a strip-line concept of the prior art.

The terminal being formed belt-like, or band-like, respectively, shall particularly mean that is has a height and a width, wherein the height may be the same as the width, or it may preferably be lower compared to the width, such as in the range of ≤25% of the width, for example in the range of ≤10% of the width, in particular in the range of ≤1% of the width. At least in said area, the terminal may thus have exemplarily an essentially rectangular cross section perpendicular to its longitudinal extension.

According to this, such an embodiment may be producible very easily and may be adapted to known techniques, which in turn allows a cost-saving production of the terminal arrangement and thus of a power semiconductor module equipped therewith. On the other hand, when forming a belt-like structure, the effect of the at least one shield member may be defined especially effectively.

As generally the shielding region may only be a defined part of the terminal, thus, according to this embodiment, next to the shielding region being formed belt-like, the external terminals may generally have further portions which are not formed belt-like but which may be formed in a further geometry. On the other hand, it may be provided that the whole terminal may have a belt-like form and the shielding region may thus be a defined part of the whole belt-like form.

According to a further embodiment, the shielding region of the first external terminal and the shielding region of the second external terminal at least partly are aligned parallel to each other in a common first plane, the first plane being formed by the width and the height of the first external terminal and the second external. The terminal being aligned in a plane should thus particularly mean that the width and the height of said terminal proceed parallel to this plane and in this plane. According to this embodiment, it is thus possible to arrange the terminals next to each other, referring to the width which proceeds in a common plane. In case the width of the terminals is aligned horizontally. Especially this embodiment allows applying a terminal design which accepts respective creepage and clearance distances e.g. between a positive and a negative DC terminal and thereby allowing a low inductance without having problems of arranging the terminals like known from the stripline concept.

With this regard, it may be especially advantageous that the at least one shield member is at least partly aligned in a second plane, the second plane being parallel to the first plane and spaced apart from the first plane in a direction normal to the first plane and the second plane, and that the at least one shield member at least partly overlaps at least one of the first terminal and the second terminal, or their shielding regions, in a direction that is arranged normal to the first and the second plane. With this regard, again, no short-circuit between the terminals should be allowed. Therefore, the shield member should be fully spaced apart from the terminals and may thus at least in the overlapping region fully be in the second plane, or it may only be in the second plane at one of the terminals in order to permit a short circuit, whereas it may be located in contact to the further terminal, in case only one shield member is provided.

It may be especially advantageous that the at least one shield member fully overlaps at least one of the first terminal and the second terminal in a direction that is arranged normal to the first and the second plane, and especially that the at least one shield member fully overlaps both of the first terminal and the second terminal in a direction that is arranged normal to the first and the second plane.

Further, the distance of the first plane and the second plane corresponds to the distance between the respective terminal and shield member like described above.

It may be provided that one common shield member overlaps both terminals and thus additionally the distance between the terminals. However, in case two shield members are provided, it may be provided that the distance between the terminals is not fully overlapped. In the latter case, like described above, the maximum distance between the shield members is smaller compared to the maximum distance, or minimum distance, between the terminals. In other words, in case a gap is provided between the shield members, the latter is smaller compared to a gap of the terminals at the respective position.

According to this embodiment, the stray inductance may be reduced especially effectively for terminals which are arranged next to each other in case the width is aligned horizontally. Therefore, the design freedom and therefore the adaption to the respective requirements may be improved, without negatively influencing the working behaviour of the power module.

In detail, the inductance in this embodiment is essentially independent of the lateral distance of the terminals. Therefore, a high distance between the terminals in order to satisfy creepage and clearance requirements is no longer penalized by large stray inductance.

This embodiment may be realized especially advantageously in case the shield member is as well formed belt-like, or band-like, at least in part, which may be realized independently from the respective embodiment. However, such a configuration of the shield member may be used independently of the respective embodiment.

According to a further embodiment, it is provided that the shielding region of the first external terminal is at least partly aligned in a third plane and that the shielding region of the second external terminal is at least partly aligned in a fourth plane, the third plane being parallel to the fourth plane and spaced apart from the fourth plane in a direction normal to the third plane and the fourth plane and wherein the shielding region of the first terminal at least partly, for example completely, overlaps the shielding region of the second terminal in a direction that is arranged normal to the third and the fourth plane. With this regard, the longitudinal direction of the first and second terminal may be parallel to each other. This arrangement is thus an arrangement in which, in other words, the terminals may be aligned parallel to each other and, in a horizontal alignment of the third and fourth plane are arranged one above the other. The distance between the third and the fourth plane, or between the respective terminals in a direction normal to the third plane and the fourth plane may lie in the double range which is described above for the distance of the shield member to the respective terminal.

According to this embodiment, it may be provided that the at least one shield member is aligned in a fifth plane, the fifth plane being parallel to the third plane and the fourth plane and spaced apart from the third plane and the fourth plane in a direction normal to the third plane and the fourth plane, and wherein the at least one shield member at least partly, for example completely, overlaps at least one of the shielding region of the first terminal and the shielding region of the second terminal in a direction that is arranged normal to the third plane and the fourth plane.

With this regard, it may be provided that, in a direction normal to the third, fourth and fifth plane, the shield member is arranged between the first and the second external terminal. It may further be provided that the fifth plane is located spaced apart normal to the third plane in a first direction and that a further shield member is present aligned in a sixth plane, the sixth plane being parallel to the fifth plane and is located spaced apart normal to the fourth plane in a second direction, the second direction being opposite the first direction, wherein the fifth and sixth plane are located outside the third and the fourth plane. In other words, two shield members may be provided which are located outside the terminals.

Further, again, this embodiment may be realized especially advantageously in case the shield member is as well formed belt-like, or band-like, at least in part.

According to this embodiment, the electromagnetic field which is originated from the belt-like shielding areas may be especially small, so that according to this embodiment, stray inductance may be lowered especially advantageously.

According to a further embodiment, at least one shield member at least partly surrounds the shielding region of the first terminal, and at least one shield member at least partly surrounds the shielding region of the second terminal. In other words, the first and the second external terminal is surrounded by one or more shield members at at least one position at the shielding region. It may thus be provided that a plurality of more than one shield member surrounds the one or more terminals at more than one position, or that a surrounding is performed by one or a plurality of shield members at one position. This embodiment allows an especially effective shielding of the electromagnetic field originated from said shielding region of the one or more terminals. It may be especially preferred that the one or more shield members surround the one or more terminals in a direction perpendicular to the longitudinal alignment of the respective terminal. It may further be provided that, in case two terminals are surrounded by the one or more shield members, this may be realized in that the terminals are surrounded together for example by one or more shield members, or that each of the terminals is fully surrounded as such.

According to a further embodiment, at least one shield member is formed as an electrically conductive element. As an example, said element may be present as a stand alone part, or it may be arranged at a support. Further, said layer may be formed belt-like, or band-like, respectively and/or may be formed as a layer. The element may be preformed and fixated to a support after producing it, or it may be formed on the support, such as by deposition methods, etc. Therefore, this embodiment may allow forming the shield member very easily and with known techniques. Further, due to the fact that an electrically conductive element may be adapted with regard to thickness, dimensions and geometrical forms without problems, an adaption to the desired application and shield strength may be achieved very effectively and easily.

As an example, the electrically conductive element is a metallic element. Exemplarily, the metallic element may comprise copper or aluminum. Such an embodiment may allow an effective shielding measure regarding the electromagnetic field and may further be produced very easily. However, it is clear for the skilled person that the metallic element has to be formed like described above for the shield member.

According to a further embodiment, the electrically conductive element is part of a shielding arrangement, the shielding arrangement comprising an electrically insulating main body, the electrically insulating main body having a front side and a back side, wherein the back side is fixated to said electrically conductive element, and wherein the front side is fixated to a first metallic structure which is fixated to the first external terminal and wherein the front side is fixated to a second metallic structure which is fixated to the second external terminal.

In order to prevent a short-circuit, the first metallic structure and the second metallic structure are electrically insulated from each other.

Electrical contact and fixation between the metallic structures and the respective terminals can be established using soldering, conductive adhesives, or simply by the pressure due to bending of the terminals during assembly. The assembly might thereby be especially easy as no large area is required and low Ohmic contact is needed, only.

The metallic structures may be formed of a patterned metallization, for example. The metallic structures may exemplarily as well be formed from copper or aluminum. Further, like described with regard to the electrically conductive layer, such metallic structures may be preformed and fixated to a support, or it may be formed on the support, such as by deposition methods, etc.

It thus becomes clear that the back side of the main body, which main body may act as support for the shield member, is directed towards said shield member, whereas the front side is directed towards the one or more terminals.

The provision of such metallic structures may allow a secure and reliable fixation of the shield arrangement to the one or more terminals.

For example, the shield arrangement may be formed as particularly flexible foil. This allows an especially easy integration into the module and an easy fixation to the one or more terminals.

Further, the terminals may be placed in close proximity to a conducting element, i.e. the shield member, which shields the magnetic field and thereby lowers inductance. Using solid insulation as main body, the distance between the terminals and the conducting sheet can be chosen very small and further in a constant manner, in case no direct contact is provided. This allows an effective and further well predictable shielding effect, allowing the inductance to be reduced in a very reliable and defined manner. Apart from that, the terminal arrangement may be integrated into the power module housing easily thereby using state-of-the art manufacturing techniques.

The shield arrangement may be integrated in a module housing and electrical contact between the patterned frontside and the module terminals may be established during assembly. The backside of the flexible foil shields the magnetic field like described above.

Regarding the main body, it may be provided that the main body is formed from a polymeric material. As an example, a polyimide may be used for forming the main body, such as the one being purchasable by the firm DuPont under its name Kapton. According to this, a material may be used which has a high electric breakdown field. Therefore, the breakdown distance between the conductive layers on the front and on the backside of the arrangement may be kept especially small. This allows the whole arrangement to be formed in a small thickness, thus allowing especially easily a flexible foil structure. Apart from that, due to small extension of the shield arrangement, the terminal arrangement may be placed in a conventional module housing without further requirements.

Generally, the main body may be formed of a material which comprises a breakdown field in the range of ≥5kV/mm, particularly ≥ 50kV/mm or even significantly more, such as of ≥ 150kV/mm. The breakdown field may be determined according to ASTM D149-09(2013).

To avoid partial discharge, it might also be advantageous to shape the edges of the terminals and/or the metallic structures for example by rounding them.

As there is no large current flowing in the metallic structures at the front side of the shielding arrangement, its electrical resistance does not have to be very small. The thickness can be chosen similar to the skin depth at the typical frequency of current transients, such as typically equal or less than 100µm.

Like described above, the shield member can be on floating potential. However, it can also be connected to an arbitrary potential (e.g., DC+, DC- or AC) and insulated to all respective bodies on different potential.

Regarding further technical features and advantages of the terminal arrangement as described, it is referred to the description of the power semiconductor module, the figures and the description of the figures, and vice versa.

The present invention further relates to a power semiconductor module, comprising an electronic circuit with at least one power semiconductor device, wherein the power semiconductor module comprises at least one terminal arrangement like described above for externally contacting the electronic circuit.

The power semiconductor module thus comprises at least one electrical circuit, which may be generally equipped like it is known in the art. With this regard, an electronic circuit of a power semiconductor module as it is generally known in the art may mainly comprise at least one power semiconductor device, such as a transistor, e.g. a MOSFET or an IGBT, and/or a diode, which at least one power semiconductor device is connected to an electrically conductive structure.

The power semiconductor module further comprises at least one terminal arrangement according to the above description for externally contacting the electronic circuit.

The external terminal of said terminal arrangement may exemplarily serve for contacting such an electrically conductive structure at its one end of its longitudinal extension and may provide an external connection point, for example outside a housing of the module, at the opposite end of the longitudinal direction of the external terminal.

Like discussed above in detail, such a power semiconductor module has the advantage of an easy production combined with a working mode having low stray inductance.

According to an embodiment, the module comprises a module housing wherein the at least one shield member is provided at least partly inside the module housing. Preferably, the at least one shield member, i.e. the one or more shield members, are provided completely inside the module housing. Mostly, such housings are formed from a polymeric material due to electrical insulation matters. Especially positioning the at least one shield member at least partly, preferably completely, inside the housing may provide an especially effective reduction of the magnetic field and thus may effectively reduce stray inductance. Further, the production of the module may further be improved.

It is further possible according to the present invention, that the shield member, or shield arrangement, as described above, extends until the electrical connectors at the electrical circuit, such as to the gate, exemplarily the gate pad, or gate pads, respectively. It may thus proceed directly from the electrical circuit to the housing.

According to a further embodiment, at least one of the first external terminal and the second external terminal is connected to the electrical circuit such that that at least one of the first external terminal and the second external terminal of the terminal arrangement forms a positive external direct current terminal, a negative external direct current terminal, an alternating current terminal, an emitter terminal, or a collector terminal. Especially providing the at least one shield member in proximity to a positive and/or negative DC terminal may be advantageous, as during the IGBT and diode switching event, for example, the stray inductance of the internal IGBT module design are creating an overvoltage at the semiconductor terminals. With the reduction of the internal stray inductance, this overvoltage can be reduced, like it is described in detail above. Regarding an emitter and a collector terminal, as well an effective shielding may be reached.

According to a further embodiment, the power semiconductor module comprises at least one transistor which is based on a wide bandgap semiconductor. In particular, it is preferred that the electrical circuit which is contacted by the terminal arrangement is equipped with a transistor which is based on a wide bandgap semiconductor. Especially with regard to wide bandgap semiconductors, the stray inductance should be decreased in order to maintain a good switching behaviour. Therefore, the power semiconductor module as described above is especially advantageous for such wide bandgap semiconductors being present in the power semiconductor transistors. Such semiconductor devices are based for example on silicon carbide (SiC) or gallium nitride (GaN). As an explanation but without being limited thereto, "wide" bandgap semiconductors typically refer to a material with a band gap of at least three eV. Such a band gap is significantly greater than these of the commonly used semiconductors, such as silicon (1.1 eV) or gallium arsenide (1.4 eV).

Especially packages for fast switching semiconductors, for example for the emerging SiC market, have to have low stray inductance which can handle short current rise-times. Therefore, the terminal arrangement as described above is especially advantageous for wide bandgap semiconductors.

Regarding further technical features and advantages of the power semiconductor module as described, it is referred to the description of the terminal arrangement, the figures and the description of the figures, and vice versa.

### Brief description of drawings

Additional features, characteristics and advantages of the subject-matter of the invention are disclosed in the subclaims, the figures and the following description of the respective figures and examples, which -in an exemplary fashion- show embodiments and examples of terminal arrangements according to the invention.

In the figures:
Figure 1 shows an embodiment of two external terminals which may be part of a terminal arrangement according to the invention;
Figure 2 shows a further embodiment of two external terminals which may be part of a terminal arrangement according to the invention;
Figure 3 shows an embodiment of a terminal arrangement according to the invention in a side view;
Figure 4 shows the embodiment of figure 3 in a cutaway top view;
Figure 5 shows the electromagnetic field of two terminals placed next to each other;
Figure 6 shows the effect of a shield member for the electromagnetic field according to figure 5;
Figure 7 shows the electromagnetic field of two terminals placed above each other;
Figure 8 shows a terminal arrangement according to the invention in a housing of a power semiconductor module;
Figure 9 shows a further terminal arrangement according to the invention in a housing of a power semiconductor module;
Figure 10 shows a further embodiment of a terminal arrangement according to the invention; and
Figure 11 shows a further embodiment of a terminal arrangement according to the invention.

### Description of embodiments

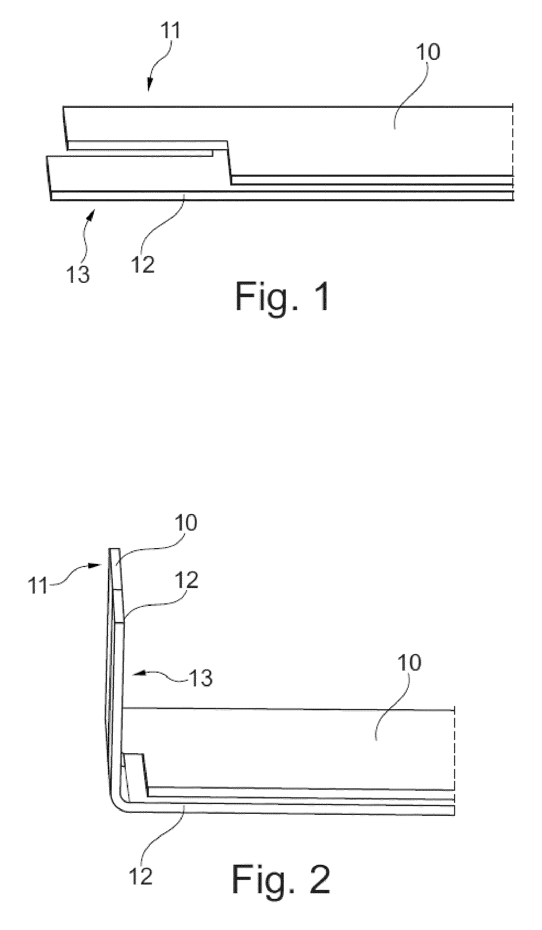

In figures 1 and 2, two external terminals 10, 12 are shown. In detail, a first external terminal 10 and a second external terminal 12 are provided, wherein the first external terminal 10 is adapted to be used as a positive external direct current terminal and wherein the second external 12 terminal is adapted to be used as a negative external direct current terminal. Alternatively, the first external terminal 10 is adapted to be used as an emitter terminal and the second external 12 terminal is adapted to be used as a collector terminal.

According to figure 1, the terminals 10, 12 are pre-formed as sheets of a metal, such as of copper. According to figure 2, the terminals are bent upwards at one end which bended end may under circumstances be used for guiding the terminals 10, 12 through a module housing 34. It can be seen that inter alia in the bended portion, the terminals 10, 12 are formed belt-like and are situated next to each other.

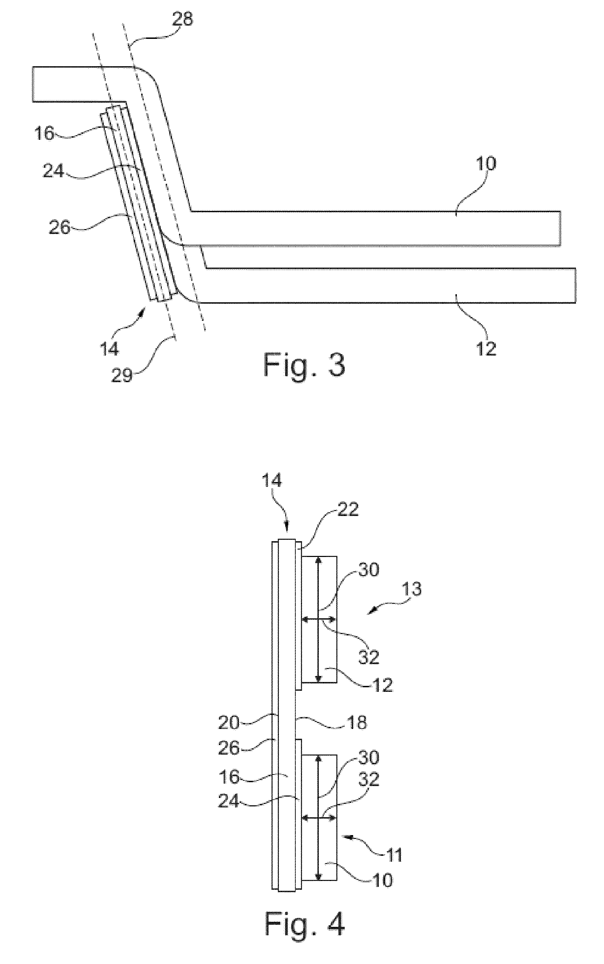

A terminal arrangement comprising such terminals 10, 12 is shown in figures 3 and 4, wherein figure 3 shows a side view and figure 4 shows a cutaway top view.

A shielding region 11 of the first external terminal 10 and a shielding region 13 of the second external terminal 12 can be seen, at which the terminals 10, 12 least partly are aligned parallel to each other in a common first plane 28, first plane 28 being formed by the width 30 and the height 32 of the first external terminal 10 and the second external terminal 12..

Further, a shield member 26 is provided for at least partly shielding an electromagnetic field 15 originated from the shielding region 11 of the first external terminal 10 and from the shielding region 13 of the second external terminal 12. In the shielding region 11 of the first external terminal 10 and in the shielding region 13 of the second external terminal 12, the shield member 26 is located at a distance to the first external terminal 10 and at a distance to the second external terminal 12 in a direction perpendicular to a longitudinal extension of first external terminal 10 and the second external terminal 12, wherein the distance is equal or less than at least one of the maximum width 30 of the first external terminal 10 and the second external terminal 12 in said shielding region 11, 13 of the first external terminal 10 and the second external terminal 12, and the maximum distance between the first external terminal 10 and the second external terminal 12 in said shielding region 11, 13 of the first external terminal 10 and the second external terminal 12.

With this regard, it can be seen that the longitudinal extension of the first 10 and second terminal 12 lies in the first plane 28 and, as it is generally known in the art, goes from the one end of the terminal 10, which may be connected to the electrical circuit, to a further and of the terminal 10, which may be located outside a housing 34 and which may be connected to a busbar, wherein the longitudinal extension may be seen in the middle of the terminal, regarding both the width 30 and the height 32.

Regarding the shield member 26 it is further provided that shield member 26 is aligned in a second plane 29, the second plane 29 being parallel to the first plane 28 and spaced apart from the first plane 28 in a direction normal to the first plane 28 and the second plane 29, and wherein the at least one shield member 26 at least partly overlaps both the shield region 11 of the first terminal 10 and the shielding region 13 of the second terminal 12 in a direction that is arranged normal to and thus parallel to the normal of the first 28 and the second plane 29.

It is further provided that the shield member 26 is formed as an electrically conductive element, such as a metallic layer. In detail, it is provided that the electrically conductive layer, or the shield member 26, respectively, is part of a shielding arrangement 14, the shielding arrangement 14 comprising an electrically insulating main body 16, such as of a polymeric material, the electrically insulating main body 16 having a front side 18 and a back side 20, wherein the back side 20 is fixated to said electrically conductive element, and wherein the front side 18 is fixated to a first metallic structure 12 which is fixated to the first external terminal 10 and wherein the front side is fixated to a second metallic structure 14 which is fixated to the second external terminal 12.

Such a shielding arrangement 14 may respect the advantageous breakdown distance between the shield member 26 and the metallic structures 22, 24 as well as the clearance distance and creepage distance between the terminals 10, 12. In fact, as a solid insulation is applied between the metallic structures 22, 24 and the shield member 26, small distances between these can be realized even for high blocking voltages.

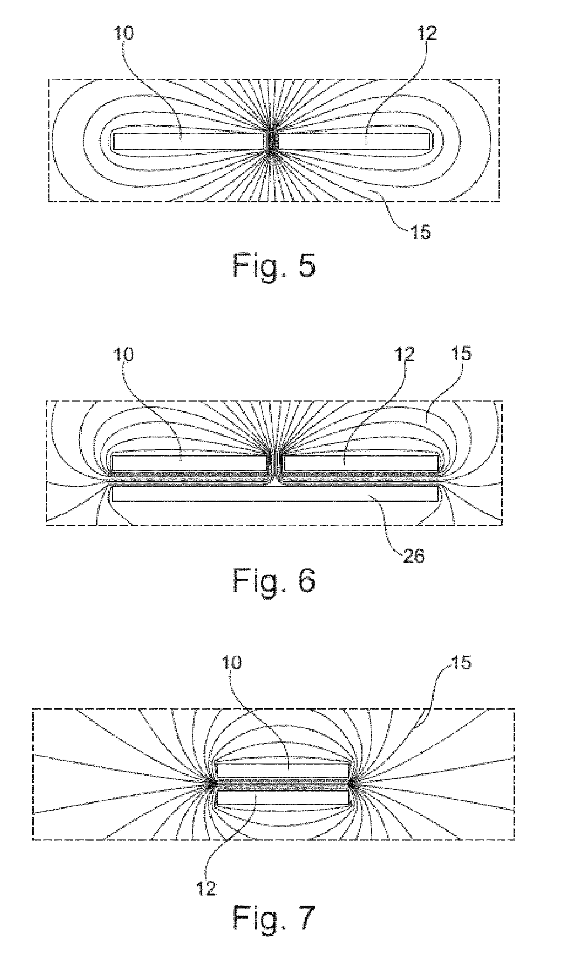

The effectivity of such a terminal arrangement is shown in figures 5 to 7. In detail the electromagnetic field 15 is visualized which is originated from shielding region 11, 13 of terminals 10, 12. It can be seen that by providing a shield member 26, the field 15 may be decreased significantly, which in turn allows reducing stray inductance as it is described in detail above. In fact, induced currents in the shield member 26 during switching transients of a power semiconductor device shield the magnetic field and lower the stray inductance. The lowest value for inductance can be obtained by stacking planar, or belt-like, respectively, shielding regions 11, 13 of terminals 10, 12 one above the other. Therefore, such a configuration may be advantageous as well by using a shield member 26.

Regarding per-length inductances of the arrangement according to figure 5, this value may be obtained according to the formula α log(d/w), wherein d is the distance between the terminals 10, 12 and w is the width 30 and α is a proportionality sign. Regarding figure 6 and thus an embodiment of the invention, the per-length inductance is obtainable by α (h/2w), wherein h is the distance from the terminal and the shield member 26 and w is the width of the terminals 10, 12, in case the width is the same. It becomes clear, that the per-length inductance now is independent of the distance between the terminals. Therefore respective clearance and creepage distances may be achieved without negatively influencing the stray inductance. Regarding per-length inductances of the embodiment according to figure 7, this value may be obtained according to the formula α (d/w), wherein d is the distance between the terminals 10, 12 and w is the width 30.

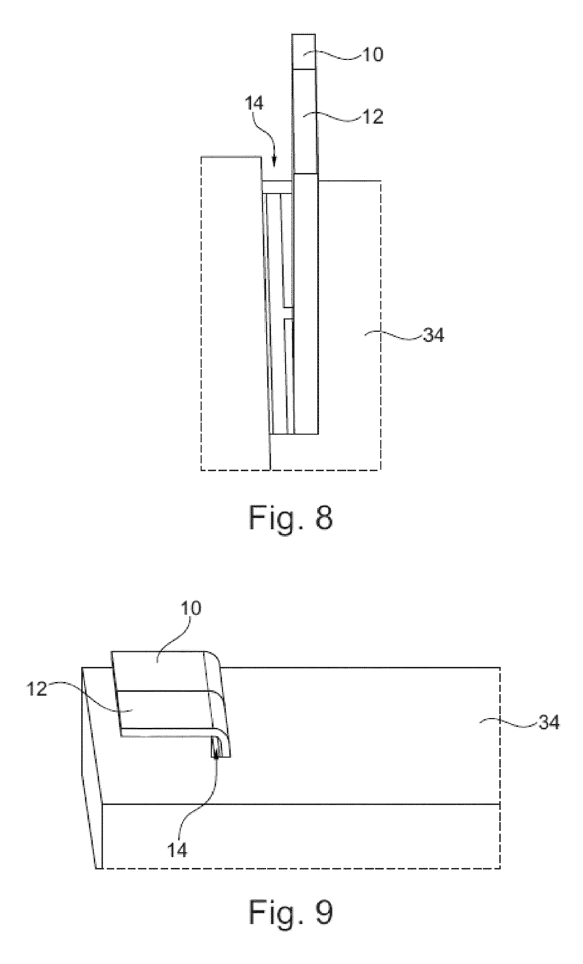

In figures 8 and 9, the position of a terminal arrangement in a housing 34 of a power semiconductor module is shown. In detail, it is shown that the shield member 26, and thus the shielding arrangement 14, is provided inside said housing 34, which may be formed of a polymeric material, for example. The terminals 10, 12 proceed from the inside of the housing 34 to its outside and thus through the housing 34, in order to electrically contact said terminals 10, 12.

The embodiment of figure 8 may be converted into the embodiment of figure 9 simply by bending the respective terminals 10, 12. Thereby, the terminals 20, 12 may be pressed against the shielding arrangement 14.

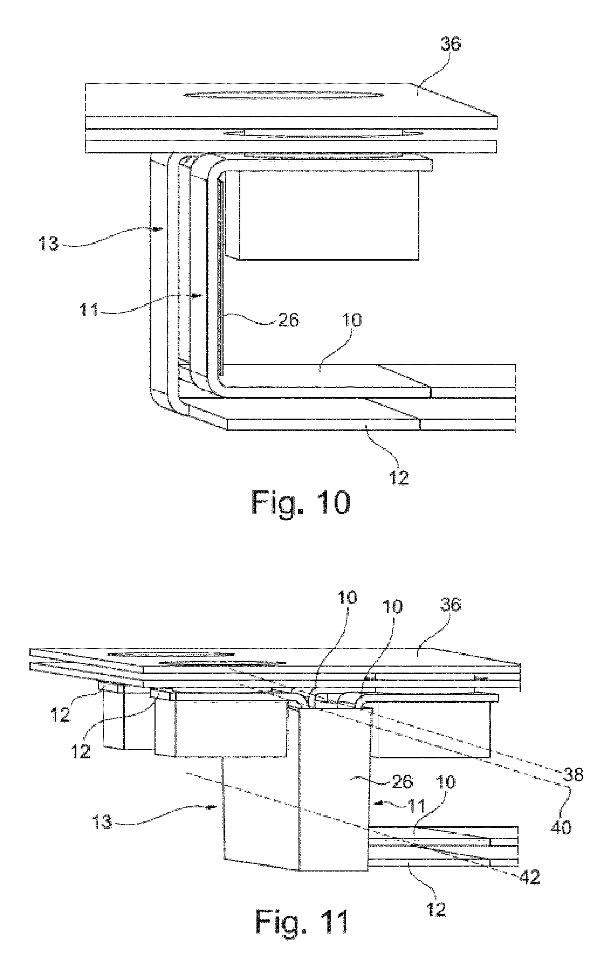

Figures 10 and 11 show further embodiments of a terminal arrangement according to the invention.

In figure 10, again, the terminals 10 and 12, or their shielding regions 11, 13, respectively, are arranged next to each other regarding the width 32 of the shielding regions 11, 13 of the terminals 10, 12 and a shield member 26 is provided for shielding an electromagnetic field. Further, the terminals 10, 12 are externally connected to a busbar 36. Such an embodiment may be provided for a low current module. Simulations showed that providing a shield member 26 being part of a shielding arrangement 14 as described above may reduce the stray inductance from about 28nH to 18nH and thus of 10nH, in an exemplary manner.

According to figure 11 it can be seen, that the shielding region 11 of the first external terminal 10 is at least partly arranged in a third plane and that the shielding region 13 of the second external terminal 12 is at least partly arranged in a fourth plane, the third plane being parallel to the fourth plane and spaced apart from the fourth plane in a direction normal to the third plane and the fourth plane. Further, the shielding region 11 of the first terminal 10 fully overlaps the shielding region of the second terminal 12 in a direction that is arranged normal to third and the fourth plane. With this regard, the third plane proceeds vertically through the line 38 and thus through the terminal 10 in its vertical position and the fourth plane proceeds vertically through the line 40 and thus through the terminal 12 in its vertical position.

Such embodiment may be used for medium to high current modules.

Regarding the shield member 26, it is shown that the shield member 26 is aligned in a fifth plane, the fifth plane being parallel to the third plane 38 and the fourth plane 40 and spaced apart from the third plane and the fourth plane in a direction normal to the third plane 38 and the fourth plane 40, and that the at least one shield 26 member at least partly overlaps at least one of the first terminal 10 and the second terminal 12 in a direction that is arranged parallel to the normal of the third plane 38 and the fourth plane 40. With this regard, the fifth plane proceeds vertically through the line 42 and this through the shield member 26 in its vertical position.

In detail, according to figure 11, it is shown that the shield member 26 at least partly surrounds the shielding regions 11, 13 of the terminals 10, 12. It is therefore aligned not only in the fifth plane. But also in a sixth plane, parallel to the fifth plane.

Simulations showed that providing a shield member 26 being part of a shielding arrangement 14 as described above may reduce the stray inductance from about 5,1 nH to 4,2nH and thus of approximately 1nH, in an exemplary manner and thus in a range of 20-30%.
While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

### Reference signs list

- 10: terminal
- 11: shielding region
- 12: terminal
- 13: shielding region
- 14: shielding arrangement
- 15: electromagnetic field
- 16: main body
- 18: front side
- 20: back side
- 22: metallic structure
- 24: metallic structure
- 26: shield member
- 28: first plane
- 29: second plane
- 30: width
- 32: height
- 34: housing
- 36: busbar
- 38: line
- 40: line
- 42: line

## Claims

1. Terminal arrangement for externally contacting an electronic circuit of a power semiconductor module, the terminal arrangement comprising a first external terminal (10), a second external terminal (12) and at least one shield member (26) for at least partly shielding an electromagnetic field (15) originated from said first external terminal (10) and said second external terminal (12), wherein in a shielding region (11) of the first external terminal (10) at least one shield member (26) is located at a distance to the first external terminal (10) in a direction perpendicular to a longitudinal extension of first external terminal (10) and wherein and in a shielding region (13) of the second external terminal (12) at least one shield member (26) is located at a distance to the second external terminal (12) in a direction perpendicular to a longitudinal extension of second external terminal (12), wherein the distance is equal or less than at least one of the maximum width (30) of the first external terminal (10) and the second external terminal (12) in said shielding region (11, 13) of the first external terminal (10) and the second external terminal (12), and the maximum distance between the first external terminal (10) and the second external terminal (12) in said shielding region (11, 13) of the first external terminal (10) and the second external terminal (12).

2. Terminal arrangement according to claim 1, wherein a shield member (26) is provided for at least partly shielding a magnetic field (15) from the shielding region (11, 13) of both the first external terminal (10) and the second external terminal (12), wherein the shield member (26) is fully electrically insulated from at least one of the first external terminal (10) and the second external terminal (12).

3. Terminal arrangement according to claim 1, wherein a first shield member (26) is provided for at least partly shielding a magnetic field (15) from the shielding region (11) of the first external terminal (10) and wherein a second shield member (26) is provided for at least partly shielding a magnetic field (15) from the shielding region (13) of the second external terminal (13), wherein the maximum distance between the first and the second shield member (26) in the shielding region (11, 13) is smaller than the maximum distance between the first external terminal (10) and the second external terminal (12) in the shielding region (11, 13).

4. Terminal arrangement according to any of claims 1 to 3, wherein the shielding region (11) of the first external terminal (10) and the shielding region (13) of the second external terminal (12) are formed belt-like.

5. Terminal arrangement according to claim 4, wherein the shielding region (11) of the first external terminal (10) and the shielding region (13) of the second external terminal (12) at least partly are aligned parallel to each other in a common first plane (28), the first plane (28) being formed by the width (30) and the height (32) of the first external terminal (10) and the second external terminal (12).

6. Terminal arrangement according to claim 5, wherein the at least one shield member (26) is at least partly aligned in a second plane (29), the second plane (29) being parallel to the first plane (28) and spaced apart from the first plane (28) in a direction normal to the first plane (28) and the second plane (29), and wherein the at least one shield member (26) at least partly overlaps at least one of the first terminal (10) and the second terminal (12) in a direction that is arranged normal to the first plane (28) and the second plane (29).

7. Terminal arrangement according to claim 4, wherein the shielding region (11) of the first external terminal (10) is at least partly aligned in a third plane and wherein the shielding region (13) of the second external terminal (12) is at least partly aligned in a fourth plane, the third plane being parallel to the fourth plane and spaced apart from the fourth plane in a direction normal to the third plane and the fourth plane and wherein the shielding region (11) of the first terminal (10) at least partly overlaps the shielding region (13) of the second terminal (12) in a direction that is arranged normal to the third plane and the fourth plane.

8. Terminal arrangement according to claim 7, wherein the at least one shield member (26) is aligned in a fifth plane, the fifth plane being parallel to the third plane and the fourth plane and spaced apart from the third plane and the fourth plane in a direction normal to the third plane and the fourth plane, and wherein the at least one shield member (26) at least partly overlaps at least one of the shielding region (11) of the first terminal (10) and the shielding region (13) of the second terminal (12) in a direction that is arranged normal to the third plane and the fourth plane.

9. Terminal arrangement according to any of the preceding claims, wherein at least one shield member (26) at least partly surrounds the shielding region (11) of the first terminal (10), and wherein at least one shield member (26) at least partly surrounds the shielding region (13) of the second terminal (12).

10. Terminal arrangement according to any of the preceding claims, wherein at least one shield member (26) is formed as an electrically conductive element, particularly as a metallic element.

11. Terminal arrangement according to claim 10, wherein the electrically conductive element is part of a shielding arrangement (14), the shielding arrangement (14) comprising an electrically insulating main body (16), the electrically insulating main body (16) having a front side (18) and a back side (20), wherein the back side (20) is fixated to said electrically conductive element, and wherein the front side (18) is fixated to a first metallic structure (12) which is fixated to the first external terminal (10) and wherein the front side (18) is fixated to a second metallic structure (14) which is fixated to the second external terminal (12).

12. Power semiconductor module, comprising an electronic circuit with at least one power semiconductor device, **characterized in that** the power semiconductor module comprises at least one terminal arrangement according to any of the preceding claims for externally contacting the electronic circuit.

13. Power semiconductor module according to claim 12, wherein the power semiconductor module comprises a module housing (34) and wherein the at least one shield member (26) is provided at least partly inside the module housing (34).

14. Power semiconductor module according to claim 12 or 13, wherein at least one of the first external terminal (10) and the second external terminal (12) of the terminal arrangement is connected to the electrical circuit such, that at least one of the first external terminal (10) and the second external terminal (12) of the terminal arrangement forms a positive external direct current terminal, a negative external direct current terminal, an alternating current terminal, an emitter terminal, or a collector terminal.

15. Power semiconductor module according to any of claims 12 to 14, wherein the power semiconductor module comprises at least one transistor which is based on a wide bandgap semiconductor.
